Europäisches Patentamt

European Patent Office

Office européen des brevets

(19)

(11) Veröffentlichungsnummer: **0 066 843**
**B1**

(12) **EUROPÄISCHE PATENTSCHRIFT**

(45) Veröffentlichungstag der Patentschrift:
13.08.86

(51) Int. Cl.⁴: **G 01 R 13/22**

(21) Anmeldenummer: 82104853.5

(22) Anmeldetag: 03.06.82

(54) Digitales Messgerät mit Flüssigkristall-Bildschirm.

(30) Priorität: 06.06.81 DE 3122558

(43) Veröffentlichungstag der Anmeldung:
15.12.82 Patentblatt 82/50

(45) Bekanntmachung des Hinweises auf die Patenterteilung:
13.08.86 Patentblatt 86/33

(84) Benannte Vertragsstaaten:
AT BE CH FR GB IT LI NL SE

(56) Entgegenhaltungen:
DE-A-2 806 039
FR-A-2 442 451
US-A-4 019 040

RADIO FERNSEHEN ELECTRONIK, Band 28, Nr. 9,
September 1979, Seiten 561-565, W. BOBE:
"Digitalspeicher in der Oszillografen-Messtechnik"
TEKSCOPE, Band 12, Nr. 4, Dezember 1980, Seiten
7-9, Beaverton, Oregon, USA C. BAKER: "Digital
storage and plug-in versatility distinguish new 10-
MHz 5000-series oscilloscope"
ELEKTRONIKPRAXIS, Nr. 12, Dezember 1979,
Seiten 12-18, Vogel-Verlag, Würzburg, DE. E.
WUNDERLICH: "Transientenspeicher - eines der
vielseitigsten Messgeräte in der Oszilloskopie"

(73) Patentinhaber: METRAWATT GMBH, Thomas-
Mann- Strasse 16- 20, D-8500 Nürnberg (DE)

(72) Erfinder: Haussel, Werner, Frühlingsstrasse 75,
D-8501 Feucht (DE)
Erfinder: Roppelt, Günter, Rotbuchenstrasse 33,
D-8500 Nürnberg (DE)
Erfinder: Kindermann, Robert, Dipl.- Ing.,
Brettergartenstrasse 9, D-8500 Nürnberg (DE)

(74) Vertreter: Kempe, Wolfgang, Dr., c/o BROWN,
BOVERI & CIE AG Kallstadter Strasse 1
Postfach 351, D-6800 Mannheim 31 (DE)

**Beschreibung**

Die Erfindung bezieht sich auf ein digitales Meßgerät mit einem Flüssigkristall-Bildschirm, der durch einen Walsh-Funktionsgenerator angesteuert wird, wobei das analoge Meßeingangssignal über einen Analog/Digital-Wandler eingegeben sowie in einem Bildwiederholspeicher gespeichert wird und der Walsh-Funktionsgenerator an den Bildwiederholspeicher angeschlossen ist.

Aus der DE—OS 28 06 039 ist ein Flüssigkristallanzeigevorrichtung mit einer Ansteuerungsvorrichtung und einem Flüssigkristallelement bekannt, das eine zweidimensionale aus Zeilenelektroden bestehende Matrix enthält, wobei im Betrieb pro Spalte jeweils nur ein Matrixelement angezeigt wird und die Anzeige dieses Matrixelementes immer dann erfolgt, wenn die Differenz zwischen den Signalspannungen der entsprechenden Zeilen- und Spaltenelektrode Null ist, während die Differenz der Signalspannungen zwischen den entsprechenden Zeilen- und Spaltenelektroden aller anderen Matrixelemente einen von Null verschiedenen Effektivwert aufweist. An jeder der Zeilenelektroden wird eine von dem darzustellenden Anzeigesignal unabhängige Signalspannung angelegt. Diese Signalspannungen bilden ein orthogonales Funktionensystem mit jeweils gleichem Effektivwert. An jeder der Spaltenelektroden liegt ebenfalls jeweils eine der Zeilensignalspannungen. Die Zuordnung dieser Signalspannungen zu der jeweiligen Spaltenelektrode wird durch das darzustellende Anzeigesignal gesteuert. Die Signalspannungen sind dabei Walsh-Funktionen.

Mit einem Walsh-Funktionsgenerator und einem Flüssigkristallbildschirm arbeitet auch ein aus der FR—A—2442451 bekanntes digitales Meßgerät. Hierbei wird das analoge Meßeingangssignal über einen A/D-Wandler eingegeben und in einem Bildwiederholspeicher zwischenzeitlich gespeichert. Ein Trigger und eine umschaltbare Zeitbasis bestimmen die zeitliche Abbildung des Meßeingangssignals, das nach dem Zwischenspeicher über den Walsh-Funktionsgenerator an den Bildschirm gelangt.

Bei den beiden bekannten Meßgeräten mit Flüssigkristallanzeigevorrichtung ist nachteilig, daß bei Auftreten eines Auslöseimpulses lediglich die Kurvenform vor dem Impuls dargestellt werden kann ("Vorgeschichte"), nicht jedoch die Kurvenform nach dem Impuls ("Nachgeschichte"), denn auf dem Flüssigkristall-Bildschirm kann nur das abgebildet werden, was vor dem Ausloseimpuls in einen Speicher aufgenommen wurde.

Aus Radio- und Fernsehenelektronik, Band 28, Nr. 9, September 1979, Seiten 561 bis 565 ist ein Speicheroszilloskop bekannt, bei dem mit Hilfe eines Transientenspeichers die Erfassung veränderlicher Meßsignale vor oder nach einen Triggersignal ermöglicht wird. Speicheroszillographen mit Digitalspeicher unterscheiden sich jedoch wesentlich von Meßgeräten entsprechend der Art des Anmeldungsgegenstandes. So benötigen sie nicht nur eine analog wirkende Ablenkbaugruppe, sondern das aus dem Speicher entnommene digitalisierte Meßsignal muß durch einen D/A-Wandler in eine analoge Größe zurückgeformt werden. Hinzukommt, daß sowohl bekannte Speicherozilloskope, wie auch mit nur einem Zwischenspeicher ausgestattete Flüssigkristall-Bildschirmgeräte nicht in der Lage sind, mit diesem einen Speicher die sich eingangsseitig ständig ändernden Daten aufzunehmen und gleichzeitig einen bestimmten Signalausschnitt über einen längeren Zeitraum zur Anzeige zu bringen. Mit nur einem Speicher versehene Geräte müssen die Aufnahme neuer Daten in diesen Speicher stoppen, sobald ein Trigger-Signal die Ausgabe des Speicherinhaltes bewirkt und zwar solange, bis die Ausgabe und damit die Anzeige auf dem Bildschirm beendet wird. Somit können während eines längern Zeitraums keine neuen Daten aufgezeichnet werden, was bedeutet, daß ggf. wichtige Daten verlorengehen, während die Aufzeichnung auf dem Bildschirm erfolgt.

Ausgehend von der DE—A—2 806 039 liegt der Erfindung die Aufgabe zugrunde, eine digitales Meßgerät mit einem Flüssigkristall-Bildschirm zur Darstellung zeitlich veränderbarer elektrischer Ströme und Spannungen zu schaffen, das eine Speicherung und Anzeige kontinuierlicher Signale und einmaliger Signale ermöglicht, wobei "Vorgeschichte" und "Nachgeschichte" des Signales festgehalten werden sollen und möglichst wenige der zu überwachenden Daten verlorengehen.

Diese Aufgabe wird erfindungsgemäß durch die im Anspruch 1 gekennzeichneten Merkmale gelöst. Vorteilhafte Ausgestaltungen und Weiterbildungen der Erfindung sind in den Unteransprüchen genannt.

Die mit der Erfindung erzielbaren Vorteile liegen insbesondere darin, daß bei der selbständigen Darstellung von einmalig auftretenden Strom- bzw. Spannungssignalen, z.B. Störimpulsen, auch die "Nachgeschichte" des einmalig auftretenden Signales dargestellt werden kann. Das zeitliche Verhältnis zwischen darzustellender "Vorgeschichte" und "Nachgeschichte" ist dabei stufenlos einstellbar. Durch den Transientenspeicher wird eine Entkopplung des Datenflusses auf der Eingabeseite und des Datenflusses auf der Ausgabeseite erreicht. So können zur gleichen Zeit Daten aus dem Bildspeicher ausgelesen und als Kurvenform dargestellt wirden, während der Transientenspeicher neue Daten aufnimmt. Es ist ferner das Aufzeichnen von Kurvenformen mit hohen Gleichtaktbereichen möglich.

In Ausgestaltung der Erfindung ist das Meßeingangssignal über ein Digitalvoltmeter einer Ziffernanzeige des Flüssigkristall-Bildschirmes zuführbar. Hierdurch ist neben der Darstellung der Kurvenform von Spannungen und Strömen vorteilhaft auch eine gleichzeitige Anzeige des Effektivwertes oder Mittelwertes des kontinuierlichen Signales auf der digitalen Ziffernanzeige des Bildschirmes möglich.

Gemäß einer Weiterbildung der Erfindung ist an den Bildwiederholspeicher ein Digital/Analog-Wandler mit nachgeschaltetem Vektorgenerator und nachgeschaltetem Schreiberausgang angeschlossen. Hierdurch ist vorteilhaft eine schriftliche Dokumentation des am Bildschirm angezeigten gespeicherten Bildes mit Hilfes eines Schreibers möglich.

Nach einer weiteren Ausbildung der Erfindung beträgt zur Erhöhung der Auflösung der Ziet-Achse des Flüssigkristall-Bildschirmes die Speicherkapazitat des Bildwiederholspeichers ein Mehrfaches der eigentlich benötigten Speicherkapazität Damit ist vorteilhaft ein "Zoom-Effekt" im Zeitbereich erzielbar.

Ein weiterer Vorschlag der Erfindung geht dahin, daß zur Erhöhung der Auflösung der Y-Achse des Flüssigkristall-Bildschirmes der Datenbus des Analog/Digital-Wandlers, des Transientenspeichers und des Bildwiederholspeichers überdimensioniert ist. Damit ist vorteilhaft ein "Zoom-Effekt" bei der Amplitudendarstellung erzielbar.

Ein Ausführungsbeispiel der Erfindung ist im folgenden anhand der Zeichnungen dargestellt. Es zeigen:

Fig. 1 das digitale Meßgerät mit Flüssigkristall-Bildschirm und Transientenspeicher,

Fig. 2, 3 Darstellung von Kurvenformen auf dem Bildschirm.

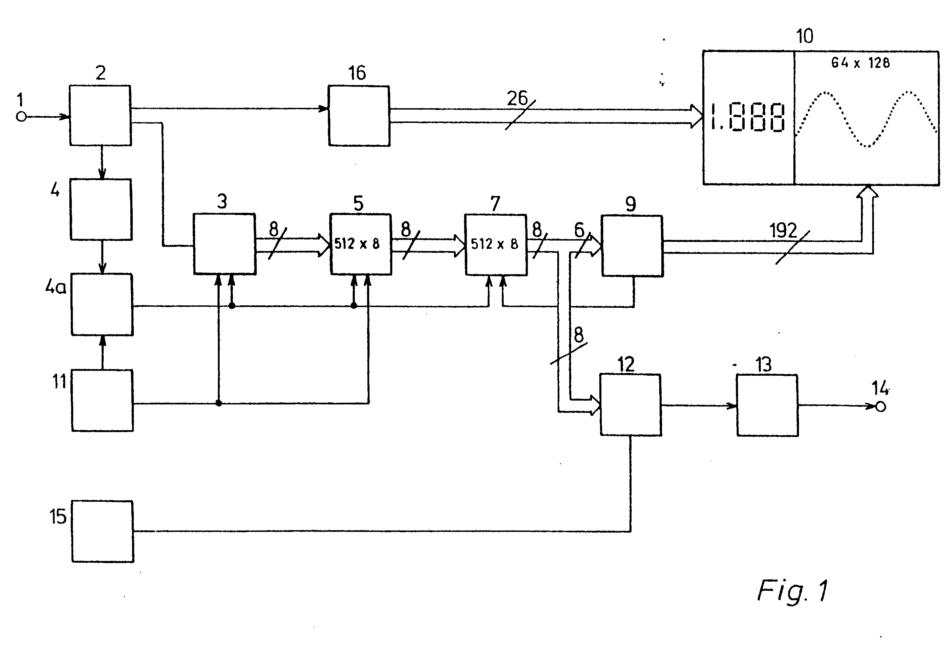

Fig. 1 zeigt das digitale Meßgerät mit Transientenspeicher und Flüssigkristall-Bildschirm. Das Meßgerät besitzt einen Meßeingang 1, der mit einer Eingangsanpassung 2 verbunden ist. Ausgangsseitig ist die Eingangsanpassung 2 einerseits mit einem Analog/Digital-Wandler 3, andererseits mit einem Trigger 4 beschaltet. Der Analog/Digital-Wandler 3 ist über eine beispielsweise 8-adrige Leitung mit einem Transientenspeicher 5 verbunden. Der Transientenspeicher 5 besitzt beispielsweise eine Speicherfähigkeit von 512.8 bit und ist über eine 8-adrige Leitung mit einem Bildwiederholspeicher 7 verbunden. Der Bildwiederholspeicher 7 weist beispielsweise eine Speicherfähigkeit von 512.8 bit auf. Bildwiederholspeicher 7 und Transientenspeicher 5 bestehen vorzugsweise aus CMOS—RAMS.

Der Bildwiederholsspeicher 7 ist über eine beispielsweise 6-adrige Leitung mit einem Walshgenerator 9 verbunden. An den Walshgenerator 9 ist über eine 192-adrige Leitung ein Flüssigkristall-Bildschirm 10 angeschlossen. Der Flüssigkristall-Bildschirm 10 weist 64. 128 Bildpunkte auf, die in einer Punktmatrix mit 64 Zeilen (Amplitudendarstellung) und 128 Spalten (Zeitbereich) zusanmmengefaßt sind.

An den Trigger 4 ist eine variable Verzögerungsleitung 4a angeschlossen. Die Verzögerungsleitung 4a ist ausgangsseitig mit dem Analog/Digital-Wandler 3, dem Transientenspeicher 5 und dem Bildwiederholspeicher 7 verbunden. An den Bildwiederholspeicher 7 ist ferner eine vom Walshgenerator 9 kommende Leitung angeschlossen. Der variablen Verzögerungsleitung 4a werden eingangsseitig Signale einer umschaltbaren Zeitbasis 11 zugeleitet. Die Zeitbasis 11 ist ausgangsseitig mit dem Digital/Analog-Wandler 3 und dem Transientenspeicher 5 verbunden.

Der Bildwiederholspeicher 7 ist uber eine 8-adrige Leitung mit einem Digital/Analog-Wandler 12 verbunden. Am Wandler 12 liegt ein Vektorgenerator 13. Am Vektorgenerator 13 ist ein Schreiberausgang 14 angeschlossen. Der Digital/Analog-Wandler 12 ist desweiteren mit einer Schreiber-Starttaste 15 verbunden. Mit dem Schreiberausgang 14 ist ein (nicht dargestellter) Schreiber verbunden. Die Eingangsanpassung 2 ist weiterhin mit einem Digitalvoltmeter 16 verbunden, das über eine beispielsweise 26-adrige Leitung an einen Ziffernanzeigeteil des Flüssigkristall-Bildschirmes 10 angeschlossen ist. Der Ziffernanzeigeteil des Bildschirmes 10 besteht z.B. aus einer dreieinhalbstelligen 7-Segmentanzeige.

Nachfolgend wird die Funktionsweise des digitalen Meßgerätes beschrieben. Das Eingangssignal wird über den Meßeingang 1 und die Eingangsanpassung 2 auf einen vom Analog/Digital-Wandler 3 verarbeitbaren Spannungspegel gebracht. Die Eingangsanpassung 2 enthält Vorwiderstände und Stromshunts zur Anpassung, die über Meßbereichsschalter umgeschaltet werden. Der Analog/Digital-Wandler 3 tastet die Kurvenform ab und lädt den Transientenspeicher 5 entsprechend. Die Wandlungsfrequenz des Wandlers 3 entspricht der Frequenz, mit der die digitalen Wörter in den Transientenspeicher 5 eingeschrieben werden und ist über die umschaltbare Zeitbasis 11 einzustellen.

Der Transientenspeicher 5 speichert so fortlaufend Informationen. Ist der Speicher 5 voll, so wird sein Inhalt von neuen Informationen überschrieben. Dies geschieht so lange, bis ein Signal mit Triggerpegel erscheint. Ist die variable Verzögerungsleitung 4a so eingestellt, daß das Triggersignal nicht verzögert wird, so wird die Analog/Digital-Wandlung und das Einspeichern der Information in den Transientenspeicher 5 unterbrochen und die vorher gespeicherte Information in den Bildwiederholspeicher 7 übertragen. Die Information kann nun unabhängig vom Transientenspeicher 5 und unabhängig von der eingestellten Zeitbasis durch den Walshgenerator 9 vom Bildwiederholspeicher 7 ausgelesen und am Bildschirm 10 angezeigt werden, während bereits wieder Informationen in den Transientenspeicher 5 eingeschrieben werden, bis das nächste Triggersignal anliegt. Zusätzlich kann der Inhalt des Speichers 7 durch Drücken der Schreiber-Starttaste 15 ausgeschrieben werden. Die einzelnen Bildpunkte werden dabei durch lineare Interpolation verbunden.

Durch Einstellen einer Verzögerung des Triggersignals an der variablen Verzögerungsleitung 4a kann die Länge der gespeicherten Vor- und Nachgeschichte (Pre- und Post-Trigger) des auslösenden Signals bestimmt werden. Wird die maximale Verzögerungszeit eingestellt (Abtastzeit. Anzahl der Speicherplätze), so wird nur die Nachgeschichte des auslösenden Signals in den Bildwiederholspeicher 7 übernommen, bei Einstellung der minimalen Verzögerungszeit wird nur die Vorgeschichte des auslösenden Signals in den Bildwiederholspeicher 7 übernommen. Der Bildwiederholspeicher 7 ist insbesondere notwendig, da der Bildschirm 10 feste, nicht veränderliche Bildwiederholraten (Bereitstellung von Bildinformationen) zur Darstellung eines stehenden Bildes benötigt. Durch den Einsatz des Transientenspeichers 5 dauert das Einschreiben der Bildinformation in den Bildwiederholspeicher 7 unabhängig von der gewählten Zeitbasis vorteilhaft nur sehr wenig Zeit. Bei großen Zeitbasen bleibt das zuletzt in den Bildwiederholspeicher 7 übernommene Bild angezeigt, bis nach einem Triggerimpuls das neue Bild übernommen wird.

Mit Hilfe der Verzögerungsleitung 4a kann das Verhältnis zwischen darzustellender Vor- und Nachgeschichte variabel aufgeteilt werden.

Zur weiteren Erläuterung der Funktionsweise von Transientenspeichern zur Speicherung von kontinuierlichen bzw. einmaligen Signalen wird auf die Veröffentlichung "Transientenspeicher—eines der vielseitigsten Meßgeräte in der Oszilloskopie", E. Wunderlich, Elektronik-Praxis, Heft 12/Dez. 1979, Vogel-Verlag Würzburg hingewiesen. Die dort beschriebenen Transientenspeicher haben jedoch keine Sichtmöglichkeiten. Sie müssen in Verbindung mit Oszillographen bzw. Schreibern betrieben werden. Dies sind in nachteiliger Weise große und schwere Geräte, die nur netzbetrieben arbeiten können.

Eine Erhöhung der Auflösung (Zoom-Effekt) sowohl in der Zeitachse (X-Achse) als auch in der Amplitudenachse (Y-Achse) des Flüssigkristall-Bildschirmes 10 wird durch eine Überdimensionierung des Analog/Digital-Wandlers 3, des Transientenspeichers 5 und des Bildwiederholspeichers 7 erzielt.

Für die Charakterisierung der Amplitude und deren Darstellung auf der Y-Achse des Flüssigkristall-Bildschirmes 10 (64 Bildpunkte) sind eigentlich lediglich 6-bit-Wörter erforderlich. Der Analog/Digital-Wandler 3 und die nachgeschalteten Speicher 5 und 7 werden jedoch auf 8-bit-Wortbreite ausgelegt. Durch Verschieben des ausgangsseitigen 6-bit-Datenbus zum eingangsseitigen 8-bit-Datenbus im Bildwiederholspeicher 7 wird somit die Auflösung am Bildschirm 10 in der Amplitudenachse verändert.

Die maximale Auflösung ergibt sich bie folgender Einstellung:

| Datenbus am Eingang des Bildwiederholspeichers 7 | Datenbus am Ausgang des Bildwiederholspeichers 7 |
|---|---|
| $2^7$ — — — — — — — — — — — — — — — — — — — — — | |
| $2^6$ — — — — — — — — — — — — — — — — — — — — | |
| $2^5$ — — — — — — — — — — — — — — — — — — | — — — — — — — — — — — $2^5$ |
| $2^4$ — — — — — — — — — — — — — — — — — | — — — — — — — — — — — $2^4$ |
| $2^3$ — — — — — — — — — — — — — — — — | — — — — — — — — — — — $2^3$ |
| $2^2$ — — — — — — — — — — — — — — — | — — — — — — — — — — — $2^2$ |
| $2^1$ — — — — — — — — — — — — — — —,— — | — — — — — — — — — — — $2^1$ |
| $2^0$ — — — — — — — — — — — — — — — — | — — — — — — — — — — — $2^0$ |

Eine mittlere Auflösung ergibt sich bei folgender Einstellung:

| Datenbus am Eingang des Bildwiederholspeichers 7 | Datenbus am Ausgang des Bildwiederholspeichers 7 |
|---|---|
| $2^7$ — — — — — — — — — — — — — — — — — — | |
| $2^6$ — — — — — — — — — — — — — — — — — — | — — — — — — — — — — $2^5$ |
| $2^5$ — — — — — — — — — — — — — — — — — — | — — — — — — — — — — $2^4$ |
| $2^4$ — — — — — — — — — — — — — — — — — — | — — — — — — — — — — $2^3$ |
| $2^3$ — — — — — — — — — — — — — — — — — — | — — — — — — — — — — $2^2$ |
| $2^2$ — — — — — — — — — — — — — — — — — — | — — — — — — — — — — $2^1$ |
| $2^1$ — — — — — — — — — — — — — — — — — — | — — — — — — — — — — $2^0$ |
| $2^0$ — — — — — — — — — — — — — — — — — — | |

Die minimale Auflösung ergibt sich bei folgender Einstellung:

| Datenbus am Eingang des Bildwiederholspeichers 7 | Datenbus am Ausgang des Bildwiederholspeichers 7 |
|---|---|
| $2^7$ — — — — — — — — — — — — — — — — — — | — — — — — — — — — — $2^5$ |
| $2^6$ — — — — — — — — — — — — — — — — — — | — — — — — — — — — — $2^4$ |
| $2^5$ — — — — — — — — — — — — — — — — — — | — — — — — — — — — — $2^3$ |
| $2^4$ — — — — — — — — — — — — — — — — — — | — — — — — — — — — — $2^2$ |
| $2^3$ — — — — — — — — — — — — — — — — — — | — — — — — — — — — — $2^1$ |
| $2^2$ — — — — — — — — — — — — — — — — — — | — — — — — — — — — — $2^0$ |
| $2^1$ — — — — — — — — — — — — — — — — — — | |
| $2^0$ — — — — — — — — — — — — — — — — — — | |

Zur Veränderung der zeitlichen Auflösung auf der X-Achse des Flüssigkristall-Bildschirmes 10 wird die Speicherkapazitat des Bildwiederholspeichers 7 auf ein Mehrfaches (z.B. 4-faches) der eigentlich benötigten Speicherkapazität (128 bit) dimensioniert. Im Ausführungsbeispiel beträgt die Speichertiefe des Speichers 7 512 Bytes.

Durch Verschieben des Adressbus im Bildwiederholspeicher 7 wird die Zietauflösung verändert.

Zur gedrängten Darstellung des gesamten Speicherbereiches des Speichers 7 auf dem Bildschirm 10 wird lediglich jede 4. Adresse dargestellt. Hierzu ist folgende Einstellung notwendig:

| Adressen am Bildwiederholspeichers 7 | Adressenzähler des Bildschirmes 10 |
|---|---|
| $2^8$ – – – – – – – – – – – – – – – – – – – – | – – – – – – – – – – $2^6$ |
| $2^7$ – – – – – – – – – – – – – – – – – – – – | – – – – – – – – – – $2^5$ |
| $2^6$ – – – – – – – – – – – – – – – – – – – – | – – – – – – – – – – $2^4$ |
| $2^5$ – – – – – – – – – – – – – – – – – – – – | – – – – – – – – – – $2^3$ |
| $2^4$ – – – – – – – – – – – – – – – – – – – – | – – – – – – – – – – $2^2$ |
| $2^3$ – – – – – – – – – – – – – – – – – – – – | – – – – – – – – – – $2^1$ |
| $2^2$ – – – – – – – – – – – – – – – – – – – – | – – – – – – – – – – $2^0$ |
| $2^1$ – – – – – – – – – – – – – – – – – – – – | |
| $2^0$ – – – – – – – – – – – – – – – – – – – – | |

Mit Hilfe eines Codierschalters werden nacheinander ein Viertel des Speicherbereichs in vierfacher Auflösung zur Anzeige gebracht, was einer Dehnung der Zeitbasis um den Faktor 4 entspricht. Es ergibt sich folgende Einstellung:

| Adressen am Bildwiederholspeichers 7 | Adressenzähler des Bildschirmes 10 |
|---|---|
| $2^8$ – – – – – – – – – – – – – – – – – – – – | – – – – – – – – – Codier- |
| $2^7$ – – – – – – – – – – – – – – – – – – – – | – – – – – – – – – schalter |
| $2^6$ – – – – – – – – – – – – – – – – – – – – | – – – – – – – – – – – $2^6$ |
| $2^5$ – – – – – – – – – – – – – – – – – – – – | – – – – – – – – – – – $2^5$ |
| $2^4$ – – – – – – – – – – – – – – – – – – – – | – – – – – – – – – – – $2^4$ |
| $2^3$ – – – – – – – – – – – – – – – – – – – – | – – – – – – – – – – – $2^3$ |
| $2^2$ – – – – – – – – – – – – – – – – – – – – | – – – – – – – – – – – $2^2$ |
| $2^1$ – – – – – – – – – – – – – – – – – – – – | – – – – – – – – – – – $2^1$ |
| $2^0$ – – – – – – – – – – – – – – – – – – – – | – – – – – – – – – – – $2^0$ |

Die Codierschaltereinstellung ist dabei wie folgt:

| Codierschalter | Adressen des Speichers 7 |
|---|---|
| 00 | 0 ... 127 |
| 01 | 128 ... 255 |
| 10 | 256 ... 383 |
| 11 | 384 ... 511 |

Die Amplitudenauflösung sowie die zeitliche Auflösung können am bereits eingespeicherten Bild verändert werden.

Der Flüssigkristall-Bildschirm 10 wird einerseits vom Digitalvoltmeter, andererseits vom Walshgenerator 9 angesteuert. Das Ansteuerprinzip des Flüssigkristall-Bildschirmes 10 mit Hilfe des Walshgenerators 9 ist aus der DE—OS 28 06 039 bekannt, zur Beschreibung der Funktion wird darauf hingewiesen.

Ein Kennzeichen der verwendeten Adressierungstechnik ist, daß die angewählten Bildpunkte ohne Spannung bleiben und an allen Hintergrundpunkten dieselbe Effektivspannung unabhängig von der Anzahl der Zeilen und Spalten liegt. Diese Spannung kann genügend groß gewählt werden, so daß ein guter Kontrast erreicht wird, da hier die optoelektrische Kennlinie des Flüssigkristalls voll durchfahren wird.

Bei einer Punktmatrix mit n Zeilen werden n unterschiedliche Binär-Spannungsverläufe (Grundfunktionen) bildunabhängig erzeugt (Ausgänge eines n-stufigen Binärzählers). Durch Verknüpfung mit der Zeilennummer n entstehen

6

die Zeilenansteuersignale, welche ein orthogonales Funktionssystem (Walsh-Funktionen) bilden und bildunanhängig sind. Für die Erzeugung der Spaltensequenzen werden die obengenannten n Grundfunktionen nicht nur mit der Spaltennummer m, sondern auch mit der Bildinformation der entsprechenden Spalte verknüpft. Zur Vereinfachung der Elektronik wird der Zähler für die Zeilennummer mit demjenigen für die Spalte kombiniert.

Der wesentliche Vorteil dieser Ansteuertechnik liegt in den geringen Anforderungen an den im Bildschirm 10 zu verwendenden Flüssigkristall. Zu beachten ist lediglich, daß nur ein Bildpunkt pro Spalte darstellbar ist. Bei schnellen Anstiegen, wie z.B. Sprungfunktionen, fehlen daher Verbindungslinien. Normale Zeitverläufe von Strömen und Spannungen sind jedoch gut darstellbar.

Die vertikale Auflösung (Amplitude) des Bildschirmes 10 wird durch die Auflösung der Digitalisierung begrenzt, im Ausführungsbeispiel durch den 8-bit-Analog/Digital-Wandler 3. Dies entspricht einer Amplitudenauflösung von 256 Punkten. Die Auflösung der Zeitbasis wird durch die Speicherkapazität der Speicher 5 und 7 begrenzt.

Zwischen der Abtastrate $f_{abtast}$ und der maximal darzustellenden Frequenz $f_{max}$ besteht folgender Zusammenhang:

$$f_{max} = f_{abtast}/K$$

(K=Konstante). Die Konstante K nimmt dabei unterschiedliche Werte für unterschiedliche Darstellungsarten an. Für eine Punktdarstellung, wie beim Bildschirm 10, beträgt K=25.

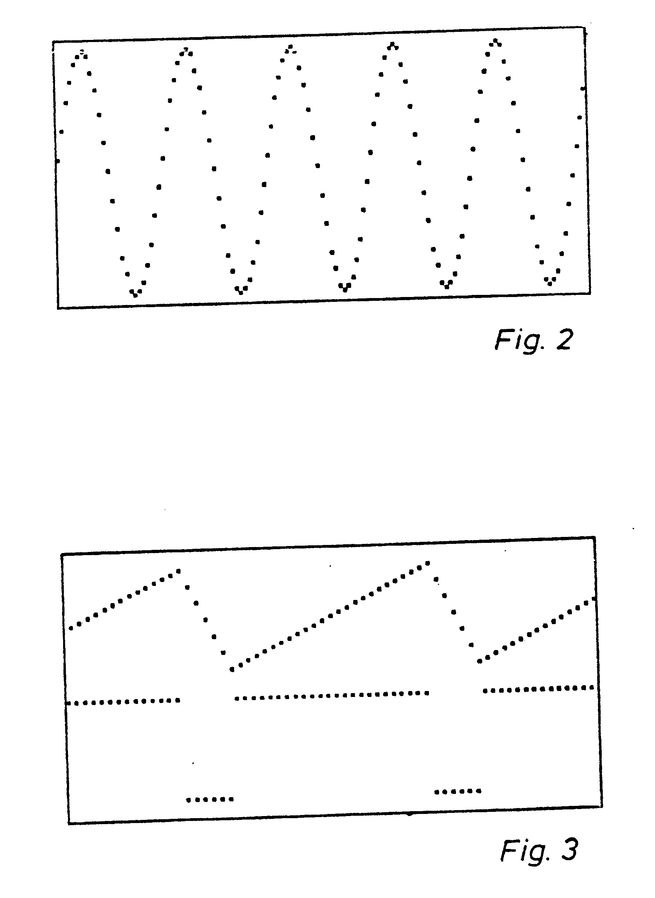

Für eine Echtzeitdarstellung, wobei für jeden dargestellten Bildpunkt eine Analog/Digital-Wandlung durchgeführt wird und eine Darstellung der Sinuskurve auf einem Punktmatrix-Bildschirm, kann also eine maximale Frequenz $f_{max}$ verarbeitet werden, die 25-mal kleiner ist als die Abtastrate $f_{abtast}$. In Fig. 2 ist eine Sinuskurve mit 25 Abtastungen pro Periode dargestellt. Der Sinuscharakter der Kurve ist noch gut zu erkennen.

Der Bildschirm 10 kann auch zur Darstellung von zwei Kurvenformen verwendet werden, wobei alternierend ein Bildpunkt der einen Variablen einem Bildpunkt der anderen Variablen folgt. Fig. 3 zeigt einen derartigen "Chopper"-Betrieb.

Für die digitale Ziffernanzeige auf dem Bildschirm 10 wird die vom Meßeingang 1 kommende Analoggröße über die Eingangsanpassung 2 dem Digital-voltmeter 16 zugeführt. Dort wird sie entweder direkt oder über einen Effektivwertewandler weiter verarbeitet. Das Digitalvoltmeter 16 enthält auch den zur Verarbeitung nötigen Analog/Digital-Wandler und den für die Ziffernanzeige notwendigen Treiber.

Mit Hilfe des Digital/Analog-Wandlers 12 und des Vektorgenerators 13 können Strom- und Spannungverläufe ausgeschrieben werden. Der Schreibvorgang wird mit der Schreiber-Starttaste 15 gestartet. Der Adresszähler des Walshgenerators 9 wird zurückgesetzt und die Auslesefrequenz des Bildwiederholspeichers 7 auf einen durch den Schreiber vorgegebenen Wert reduziert, so daß der gesamte Speicherinhalt in einer bestimmten Zeit ausgelesen wird. Durch Übergabe der Daten vom Speicher 7 auf den Digital/Analog-Wandler 12 wird jedem Digitalwert ein Analogwert zugeordnet. Mittels des Vektorgenerators 13 werden die Analogwerte durch lineare Interpolation miteinander verbunden. Für die Vektordarstellung ergibt sich der günstige Wert K=10, so daß sich die Bandbreite für den Schreiberausgang 14 vorteilhaft gegenüber der Bandbreite des Bildschirmes 10 erhöht. Von besonderem Vorteil ist dabei, daß die auszuschreibende Kurve vor dem Schreibvorgang auf dem Bildschirm 10 sichtbar ist. Dadurch kann vor dem Schreibvorgang abgewogen werden, ob die Kurve ausgeschrieben werden soll. Es ergibt sich hierdurch eine Ersparnis von Registrierpapier und von Schreibzeit.

Der Schreiberausgang 14 kann auch als Oszilloskop-Ausgang ausgelegt werden. Der Speicherinhalt des Speichers 7 wird dann mit der Frequenz des Walshgenerators auf den Digital/Analog-Wandler 12 gegeben, über den Vektorgenerator 13 linear interpoliert und auf den Oszillographen gegeben. Eine Langzeitspeicherung in den Speichern 5 und 7 kann durch Umschalten der verwendeten CMOS—RAMS auf Stand-By-Betrieb (Reservebetrieb) im ausgeschalteten Zustand des Meßgerätes bewerkstelligt werden. Ein entsprechendes Medium (Papier, Band, Floppy Disk) ist zur Speicherung vorteilhaft nicht nötig.

Ferner ist das Meßgerät bedingt durch seine geringe Größe, eine Handlichkeit und seinem geringen Strombedarf netzunabhängig betreibbar. Insbesondere ist das netzunabhängige Aufzeichnen von einmaligen Vorgängen, z.B. Störimpulsen, wobei die Speicherfähigkeit des Meßgerätes ausgenutzt wird, von Vorteil. Beim netzunabhängigen Messen treten keine direkten Verkopplungen mit der Netzversorgung auf, dadurch ergibt sich eine hohe Gleichtaktunterdrückung für Gleichtaktspannungen. Die Spannungsversorgung erfolgt dabei durch Batterien.

Der Hauptanwendungsbereich des Meßgerätes ist in der Starkstromtechnik (hoher Spannungs- und Strombereich) zu sehen. Teilgebiete wären z.B. Netzstörungen, Netzausfälle, Stromrichtertechnik, Leistungselektronik. Weitere Anwendungsgebiete wären das NF-Gebiet, Materialprüfung, Rundsteuertechnik, Bit-Mustererkennung.

**Patentansprüche**

1. Digitales Meßgerät mit einem Flüssigkristall-Bildschirm (10), der durch einen Walsh-Funktionsgenerator (9) angesteuert wird, wobei das analoge Meßeingangssignal über einen Analog/Digital-Wandler (3) eingegeben, in einem Bildwiederholspeicher (7) gespeichert, sowie durch einen Trigger (4) und eine umschaltbare Zeitbasis (11) in seiner zeitlichen Abbildung bestimmt wird und der Walsh-Funktionsgenerator (9) an den Bildwiederholspeicher angeschlossen ist, gekennzeichnet durch folgende Merkmale:

— der Analog/Digital-Wandler (3) ist über einen Transientenspeicher (5) mit dem Bildwiederholspeicher (7) verbunden,

— das Meßeingangssignal wird außer dem Analog/Digital-Wandler (3) auch dem Trigger (4) mit nachgeschalteter variabler Verzögerungsleitung (4a) zugeführt, wobei die Verzögerungsleitung (4a) ausgangsseitig mit dem Analog/Digital-Wandler (3), dem Transientenspeicher (5) und dem Bildwiederholspeicher (7) verbunden ist,

— die umschaltbare Zeitbasis (11) ist an die variable Verzögerungsleitung (4a), den Analog/Digital-Wandler (3) und den Transientenspeicher (5) angeschlossen.

2. Digitales Meßgerät nach Anspruch 1, dadurch gekennzeichnet, daß das Meßeingangssignal über ein Digitalvoltmeter (16) einer Ziffernanzeige des Flüssigkristall-Bildschirmes (10) zuführbar ist.

3. Digitales Meßgerät nach wenigstens einem der vorstehenden Ansprüche, dadurch gekennzeichnet, daß an den Bildwiederholspeicher (7) ein Digital/Analog-Wandler (12) mit nachgeschaltetem Vektorgenerator (13) und nachgeschaltetem Schreiberausgang (14) angeschlossen ist.

4. Digitales Meßgerät nach wenigstens einem der vorstehenden Ansprüche, dadurch gekennzeichnet, daß zur Erhöhung der Auflösung der X-Achse des Flüssigkristall-Bildschirmes (10) die Speicherkapazität des Bildwiederholspeichers (7) ein Mehrfaches der eigentlich benötigten Speicherkapazität beträgt.

5. Digitales Meßgerät nach wenigstens einem der vorstehenden Ansprüche, dadurch gekennzeichnet, daß zur Erhöhung der Auflösung der Y-Achse des Flüssigkristall-Bildschirmes (10) der Datenbus des Analog/Digital-Wandlers (3), des Transientenspeichers (5) und des Bildwiederholspeichers (7) überdimensioniert ist.

## Revendications

1. Appareil de mesure numérique, comportant un écran d'image à cristaux liquides (10) commandé par un générateur de fonctions de Walsh (9), le signal analogique à l'entrée de mesure étant introduit, par l'intermédiaire d'un convertisseur analogique/numérique (3), dans une mémoire de répétition d'image (7) où il est mémorisé, et ayant sa représentation dans le temps déterminée par un circuit déclencheur (4) et par une base de temps commutable (11), le générateur de fonctions de Walsh (9) étant raccordé à la mémoire de répétition d'image, caractérisé par les caractéristiques suivantes:

— c'est par l'intermédiaire d'une mémoire de transitoire (5) que le convertisseur analogique/numérique (3) est relié à la mémoire de répétition d'image (7),

— le signal à l'entrée de mesure est transmis non seulement au convertisseur analogique/numérique (3) mais aussi au circuit déclencheur (4) qui est suivi d'une ligne à retard variable (4a), laquelle est reliée, côté sortie, au convertisseur analogique/numérique (3), à la mémoire de transitoire (5) et à·la mémoire de répétition d'image (7),

— la base de temps commutable (11) est raccordée à la ligne à retard variable (4a), au convertisseur analogique/numérique (3) et à la mémoire de transitoire (5).

2. Appareil de mesure numérique selon la revendication 1, caractérisé en ce que le signal à l'entrée de mesure peut être transmis, par l'intermédiaire d'un voltmètre numérique (16), à un afficher numérique de l'écran d'image à cristaux liquides (10).

3. Appareil de mesure numérique selon au moins l'une des revendications précédentes, caractérisé en ce qu'un convertisseur numérique/analogique (12), suivi d'un générateur de vecteur (13) et d'une sortie pour traceur (14) est raccordé à la mémoire de répétition d'image (7).

4. Appareil de mesure numérique selon au moins l'une des revendications précédentes, caractérisé en ce que, pour accroître la résolution sur l'axe des X de l'écran à cristaux liquides (10), la capacité de la mémoire de répétition d'image (7) est un multiple de la capacité de mémoire naturellement nécessaire.

5. Appareil de mesure numérique selon au moins l'une des revendications précédentes, caractérisé en ce que, pour accroître la résolution sur l'axe des Y de l'écran à cristaux liquides (10), le bus de données du convertisseur analogique/numérique (3), de la mémoire de transitoire (5) et de la mémoire de répétition d'image (7) est surdimensionné.

## Claims

1. Digital measuring instrument with a liquid crystal display screen (10) which is driven by a Walsh function generator (9), the analog measurement input signal being fed in via an analog/digital converter (3), stored in an image refresh store (7), and also fixed in its display against time by a trigger (4) and a switchable timebase (11), and the Walsh function generator (9) being connected to the image refresh store, characterized by the following features:

— the analog/digital converter (3) is connected to the image refresh store (7) via a transient store (5),

— the measurement input signal, apart from being fed to the analog/digital converter (3) is fed also to the trigger (4) which is followed by a variable delay line (4a), the delay line (4a) being connected on the output side to the analog/digital converter (3), the transient store (5) and the image refresh store (7),

— the switchable time base (11) is connected to the variable delay line (11), the analog/digital converter (3) and the transient store (5).

2. Digital measuring instrument according to Claim 1, characterized in that the measurement input signal can be fed via a digital voltmeter (16) to a numerical display of the liquid crystal display screen.

3. Digital measuring instrument according to at least one of the preceding claims, characterized in that a digital/analog converter (12) followed by a vector generator (13) and followed by a recorder output (14) is connected to the image refresh store (7).

4. Digital measuring instrument according to at least one of the preceding claims, characterized in that, to increase the resolution of the X axis of the liquid crystal display screen (10), the storage capacity of the image refresh store (7) is a multiple of the storage capacity actually required.

5. Digital measuring instrument according to at least one of the preceding claims, characterized in that, to increase the resolution of the Y axis of the liquid crystal display screen (10), the data bus of the analog/digital converter (3), of the transient store (5) and of the image refresh store (7) is overdimensioned.

Fig. 1

0 066 843

Fig. 2

Fig. 3